# EUROPEAN PATENT APPLICATION

(11) **EP 2 066 033 A2**
(43) Date of publication of application: **03.06.2009**
(21) Application number: 08020142.9
(22) Date of filing: 19.11.2008
(51) Int. Cl.: H03K 17/16

(54) **Output driver and method of operation thereof**

(30) Priority: 20.11.2007 GB 0722730
(71) Applicant: Melexis NV, 8900 Leper (BE)
(72) Inventor: Vanderhenst, Henri, 3980 Tessenderlo (BE); Haemers, Iwan, 3980 Tessenderlo (BE)
(74) Representative: Wilson Gunn

(57) **Abstract**

The method of the present invention for switching an output driver 100 of the type comprising an n-mos 102 transistor and a p-mos 101 transistor configured in a push-pull arrangement operates by directly monitoring the level of the output signal OUT. The method comprises slowly switching off the input to the initially designated active transistor; monitoring the variation in output voltage level in response thereto; and when a desired change in output level is detected the switching the initially designated output transistor on completely and fast. Using this method the parasitic currents in the diodes are much smaller in time and amplitude.

## Description

The present invention relates to output drivers suitable for controlling electric motors or similar and to method of operating such output drivers.

It is often desired to control electric motors and particularly small electric motors with on chip transistors. Controlling small motors with on-chip transistors has specific problems. These are mainly at issue for small motors in low cost applications wherein the number of external components is minimized, meaning the chip must assure good performance regarding electromagnetic compatibility (EMC).

Useful control of motors typically requires fast switching of drivers. In implementing such a fast switched driver, it is usual to provide a dead time in the switching procedure so as to minimise 'pass-through' currents in the driver. Secondly, it is also usual to slowly switch the driver, so as to control the voltage gradient at the driver output, to reduce unwanted electromagnetic emissions. Thirdly, to reduce noise and dissipation, it is desirable to reduce the current flow in the parasitic diodes of the output transistors. The first two requirements above are in conflict with the third necessitating compromise in driver design and performance.

It is therefore an object of the present invention to provide a driver that, at least partially, overcomes or alleviates the above problems.

According to a first aspect of the present invention there is provided a method of switching an output driver of the type comprising an n-mos transistor and a p-mos transistor configured in a push-pull arrangement, the method comprising the following steps: slowly switching off the input to the initially designated active transistor; monitoring the variation in output voltage level in response thereto; and when a desired change in output level is detected initiating a transition procedure to complete the switching.

By monitoring whether the output level is rising or falling, the direction of current flow in the driver can be inferred. Accordingly, the initiation of the transition sequence can be optimised for the present circumstances. This results in a reduction in noise and dissipation due to current flow in the parasitic diodes of the output transistors without degrading operation in terms of minimising 'pass-through' current and controlling the output slope.

The monitoring of the output level may be carried out by a comparator. Preferably, the comparator is a fast sense comparator. A suitable form of fast sense comparator may comprise a capacitor, an amplifier and a switch wherein the switch is arranged in parallel with the amplifier.

The method may be adapted for use in a driver for controlling an electric motor.

When switching the driver output from low to high the desired change in output level may be a falling output voltage level. The related transition procedure may be rapidly switching off the input to the initially designated active transistor and rapidly switching on the input to the initially designated inactive transistor. When switching the driver output from high to low the desired change in output level may be a non-rising output voltage level or the output voltage level dropping below a predetermined threshold. The related transition procedure may be rapidly and completely switching off the input to the initially designated active transistor. After the input to the initially designated active transistor is rapidly and completely switched off, the input to the initially designated inactive transistor may be rapidly and completely switched on. The rapid switching on of the initially designated inactive transistor may be achieved by initiating the switching on of the initially designated inactive transistor based on the monitoring of the switching off of the initially designated active transistor by use of a comparator. In some implementations, between the complete switching off of the input to the initially designated active transistor and the switching on of the input to the initially designated inactive transistor, a dead period may be provided.

The driver may be arranged such that in normal operation current flows either into or out of the driver. In the present description, for the sake of clarity, the invention is described and claimed in respect of a driver arranged such that: in normal operation, current flows out of the driver; for a low output signal, the n-mos transistor is activated and the p-mos transistor is not activated; and for a high output signal, the p-mos transistor is activated and the n-mos transistor is not activated.

By way of example, in such an arrangement, in order to switch the driver output from low to high, the method may comprise slowly switching off the input to the n-mos transistor; detecting a falling output voltage level in response thereto; and then when a desired change in output level is detected rapidly switching off the input to the n-mos transistor and rapidly switching on the input to the p-mos transistor.

In such an arrangement, in order to switch the driver output from high to low, the method may comprise slowly switching off the input to the p-mos transistor; not detecting a rising output voltage level in response thereto; and continuing to slowly switch off the input to the p-mos. After the output reaches the desired low level, the input to the p-mos transistor can be rapidly and completely switched off. Subsequently, the input to the n-mos transistor can be rapidly and completely switched on. The rapid switching on of the n-mos transistor may be achieved by initiating the switching on of the n-mos transistor based on the monitoring of the switching off of the p-mos transistor by use of a comparator. In between the complete switching off of the input to the p-mos transistor and the switching on of the input to the n-mos transistor, a dead period may be provided.

It is of course immediately obvious to the skilled man that by suitable arrangement of the driver, it can be adapted to function with an oppositely directed current or with an opposite activation regime for the transistors. These variations are hereby incorporated.

According to a second aspect of the present invention there is provided an output driver suitable for controlling an electric motor, the output driver comprising an n-mos transistor and a p-mos transistor configured in a push-pull arrangement and the driver being operable in accordance with the method of the first aspect of the present.

The driver of the second aspect of the present invention may incorporate any or all features of the first aspect of the present invention as desired or as appropriate.

According to a third aspect of the present invention there is provided an electric motor controlled by an output driver according to a second aspect of the present invention or operating according to the method of the first aspect of the present invention.

The motor of the third aspect of the present invention may incorporate any or all features of the first or second aspects of the present invention as desired or as appropriate.

In order that the invention is more clearly understood, it will be described in greater detail below, by way of example only, and with reference to the accompanying drawings in which:
- Figure 1: is a schematic diagram of an output driver;
- Figure 2: is a schematic timing diagram illustrating the operation of an output driver according to the prior art
- Figure 3: is a schematic timing diagram illustrating the operation of an output driver according to the present invention; and

- Figure 4: is a schematic diagram of one possible implementation of a comparator for use in the present invention.

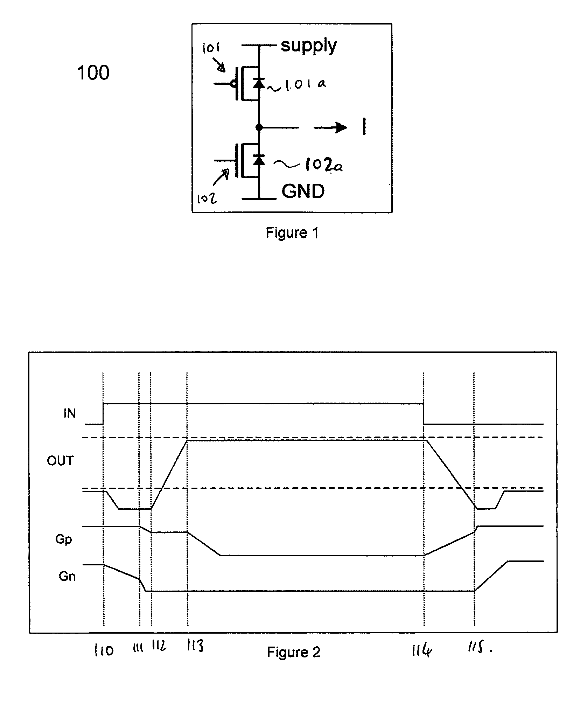

Turning now to figure 1, an output driver 100 of the push-pull type and suitable for use in controlling an electric motor comprises a complementary pair of transistors 101, 102 operable to generate a PWM current I, in the indicated direction. The two transistors are a p-mos transistor 101 and an n-mos transistor 102, having respective input signals Gₚ and Gₙ. It is of course possible to generate current in the opposite direction with a suitable arrangement of the driver components.

The figure also shows a pair of diodes 101 a and 102a. These diodes 101a, 102a are parasitic elements inherent to each transistor 101, 102. The diode 102a in parallel with the n-mos transistor 102 can conduct current from GND to the output; the diode 101a in parallel with the p-mos transistor 101 can conduct current from the output to the supply line.

In existing drivers, controlling the output voltage OUT (in presence of an applied current I) in the transition from low to high is achieved as is illustrated in the timing diagram of figure 2. Firstly, in response to the change in input signal IN at 110, the input Gₙ to n-mos transistor 102 is slowly switched off until at 111, it is concluded that Gn is 'almost' switched off. After 111, Gₙ is switched off fully as fast as possible whilst the input Gₚ to p-mos transistor 101 is slowly switched on. Gₚ remains steady until OUT has risen to its high level at 113, before slowly switching on fully. This is due to the fact the transistor 101 has an inherent capacitance between gate and drain and thus during the time the output (which is the drain of the transistor 101) is making the transition , the voltage at the gate will remain constant.

A high to low transition is achieved essentially by the inverse process. At time 114 IN changes and in response Gₚ is slowly switched off, allowing a controlled fall in OUT. When it is concluded that the Gₚ is 'almost' switched off, at 115, Gₚ is switched off fully as fast as possible whilst the Gₙ is slowly switched on, allowing OUT to stabilise at the desired low level.

This method achieves control of the output voltage without monitoring the level of the output signal OUT directly. Depending on the level of the current in the output, the voltage at the output will change slower or faster, but the controlling circuit does not know. As long as a transistor is not completely switched on, there is the possibility that current will flow in the parasitic diodes 101a, 102a. As an alternative, there can be direct monitoring of the voltage across diodes 101a and 102a supply rails 104. When it is detected that current is being drawn in the parasitic diodes 101a, 102a of the transistors, the relevant transistor 101, 102 can be reactivated to try to limit diode currents. This is a first improvement, and will decrease the current in the diodes, both in time and amplitude.

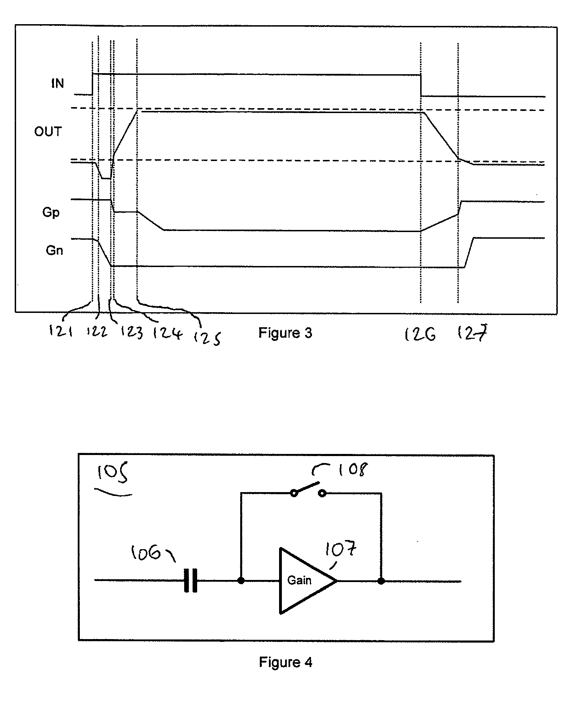

Turning now to figure 3, there is shown a timing diagram illustrating the method of the present invention for switching an output driver 100 between low and high and vice versa, for a current flowing in the direction as shown in 100; for a current in the opposite direction, similar but opposite considerations can be made. Considering the low to high transition first, the initial step, in response to the change in IN at 121 is to slowly switch off Gₙ whilst monitoring OUT. If it is detected that OUT is falling, it can be inferred that current I is flowing from the pin (If OUT is rising then it can be inferred that the current I is flowing in the opposite direction).

When it is detected that OUT is falling at 122, Gₙ is switched off as fast as possible. Subsequently at time 123, when Gₙ is completely off, Gₚ is switched on as fast as possible whilst monitoring OUT. When OUT passes its initial level at 124, Gp holds steady then slowly switches on to its high level at 125. The steady period in Gₚ is due to the inherent capacitance of transistor 101 as described above.

Considering now the transition from high to low. Initially, in response to the change in IN at 126, Gₚ is slowly switched off whilst monitoring OUT. When it is detected that OUT is falling we know that the current is flowing out of the pin. (If is rising, the current is flowing in the other direction). When OUT has substantially reached the desired low level at 127, Gₚ is switched off rapidly and completely. When it is concluded that Gₚ is 'almost' switched off after 127, Gn is switched on rapidly.

A consequence of this method of actively looking at the voltage and current at the output is that, when the output has changed state, the corresponding output transistor can be switched on completely and fast. Using this method the parasitic currents in the diodes are much smaller in time and amplitude.

In order to implement the method of the present invention, it is, as described above, necessary to monitor the output level OUT. In view of the timescales involved, this need to be done with a fast sense comparator. One suitable fast sense comparator would be a fast sense comparator of the integrator type 105, as is shown in figure 4. The comparator 105 shown comprises a capacitor 106, an amplifier 107 and a switch 108 in parallel with the amplifier. During the steady state time of the driver the switch 108 is closed, the amplifier 107 is pre-biased. When the input IN changes state, the switch 108 is opened. The input of the amplifier will capacitively follow the voltage at OUT; the amplifier 107 will amplify these changes. The voltage at the output of 107 will be compared with the relevant threshold level.

For the avoidance of doubt, there are four possible situations: 1 - transition Low to High with current into the output; 2 - transition Low to High with current out of the output; 3 - transition High to Low with current into the output; and 4 - transition High to Low with current out of the output.

Situations 1 and 4 are very similar but 'upside down'. The same is true for situation 2 and 3. Accordingly, for reasons of clarity and conciseness, in the present invention only two cases (2 and 4) are considered in detail. The invention is however envisaged to cover all four situations, as would be readily appreciated by the skilled man.

It is of course to be understood that the invention is not to be restricted to the details of the above embodiment which is described by way of example only.

## Claims

1. A method of switching an output driver of the type comprising an n-mos transistor and a p-mos transistor configured in a push-pull arrangement, the method comprising the following steps: slowly switching off the input to the initially designated active transistor; monitoring the variation in output voltage level in response thereto; and when a desired change in output level is detected initiating a transition procedure to complete the switching.

2. A method as claimed in claim 1 wherein the monitoring of the output level is carried out by a comparator.

3. A method as claimed in claim 1 wherein when switching the driver output from low to high the desired change in output level is a falling output voltage level.

4. A method as claimed in claim 3 wherein the transition procedure is rapidly switching off the input to the initially designated active transistor and rapidly switching on the input to the initially designated inactive transistor.

5. A method as claimed in claim 1 or claim 2 wherein when switching the driver output from high to low the desired change in output level is a non-rising output voltage level or the output voltage level dropping below a predetermined threshold.

6. A method as claimed in claim 5 wherein the transition procedure is rapidly and completely switching off the input to the initially designated active transistor.

7. A method as claimed in claim 6 wherein after the input to the initially designated active transistor is rapidly and completely switched off, the input to the initially designated inactive transistor is rapidly and completely switched on.

8. A method as claimed in claim 6 or claim 7 wherein the rapid switching on of the initially designated inactive transistor is achieved by initiating the switching on of the initially designated inactive transistor based on the monitoring of the switching off of the initially designated active transistor by use of a comparator.

9. A method as claimed in any preceding claim wherein the driver is arranged such that in normal operation current flows out of the driver and for a low output signal, the n-mos transistor is activated and the p-mos transistor is not activated; and for a high output signal, the p-mos transistor is activated and the n-mos transistor is not activated.

10. A method as claimed in any preceding claim wherein the driver is arranged such that in normal operation current flows into the driver and wherein for a low output signal, the p-mos transistor is activated and the n-mos transistor is not activated; and for a high output signal, the n-mos transistor is activated and the p-mos transistor is not activated.

11. An output driver suitable for controlling an electric motor, the output driver comprising an n-mos transistor and a p-mos transistor configured in a push-pull arrangement and the driver being operable to be switched in accordance with a method comprising the steps of: slowly switching off the input to the initially designated active transistor; monitoring the variation in output voltage level in response thereto; and when a desired change in output level is detected initiating a transition procedure to complete the switching.

12. An output driver as claimed in claim 12 wherein a comparator is provided to carry out the monitoring of the output level.

13. An output driver as claimed in claim 13 wherein the comparator comprises a capacitor, an amplifier and a switch wherein the switch is arranged in parallel with the amplifier.

14. An electric motor controlled by an output driver as claimed in any one of claims 12 to 14 or operating according to the method of any one of claims 1 to 11.
